Europäisches Patentamt

European Patent Office

Office européen des brevets

(11) Publication number: **0 357 205**
**A1**

## EUROPEAN PATENT APPLICATION

(21) Application number: **89307378.3**

(22) Date of filing: **20.07.89**

(51) Int. Cl.⁵: **C09K 3/14 , H01L 21/304**

(30) Priority: **28.07.88 JP 188905/88**

(43) Date of publication of application:
**07.03.90 Bulletin 90/10**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Miyajima, Motoshu**
**Haimu Kurein 1-D, 635, Noborito Tama-ku**
**Kawasaki-shi Kanagawa 214(JP)**
Inventor: **Tanaka, Akihiro**
**11-8, Aza Komatsu Oaza Uriichi**
**Hachinohe-shi Aomori 031(JP)**

(74) Representative: **Lawrence, Peter Robin**
**Broughton et al**
**GILL JENNINGS & EVERY 53-64 Chancery**
**Lane**
**London WC2A 1HN(GB)**

(54) Polishing liquid for polishing semiconductor substrate and polishing process.

(57) A polishing liquid for polishing a semiconductor substrate is formed by incorporating 0.04 to 3% by weight of an abrasive grain into an aqueous solution of an amine selected from the group consisting of ethylenediamine and hydrazine. A semiconductor substrate having an element-separating groove and an insulating film, which are formed on a semiconductor substrate, is polished with this polishing liquid after polycrystalline silicon is deposted on the semiconductor substrate.

EP 0 357 205 A1

## Polishing Liquid for Polishing Semiconductor Substrate and Polishing Process

The present invention relates to a polishing liquid for polishing a semiconductor substrate, especially for polishing a polycrystalline silicon layer in such a manner that polycrystalline silicon remains in an element-separating groove, and for polishing a dielectric substance-separately substrate, and further, to a polishing process using this polishing liquid.

Polycrystalline silicon is generally embedded in a separating groove of a semiconductor device having an insulator-separating structure, and the polishing of the polycrystalline silicon layer in such a manner that the polycrystalline silicon remains in the separating groove, or the polishing of a semiconductor substrate for forming a dielectric substance-separated substrate, is carried out by surface polishing means using an insulating film as a stopper. Accordingly, to improve the polishing accuracy, a polishing liquid must be used in which the polishing rate for the insulating film is much lower than the polishing rate for the silicon.

As typical examples of the polishing liquid used for the above-mentioned polishing, a polishing liquid formed by adding colloidal silica into an aqueous solution of an amine type substance such as a water-soluble alkylamine is marketed as a colloidal silica slurry by Nalco Chemical Co., and a polishing liquid formed by adding colloidal silica into an aqueous solution of piperazine or a derivative thereof is proposed in U.S. Patent No. 4,588,421.

Further, a polishing liquid formed by mixing alumina ($Al_2O_3$) into an aqueous solution of potassium hydroxide (KOH) is frequently used for polishing a semiconductor material.

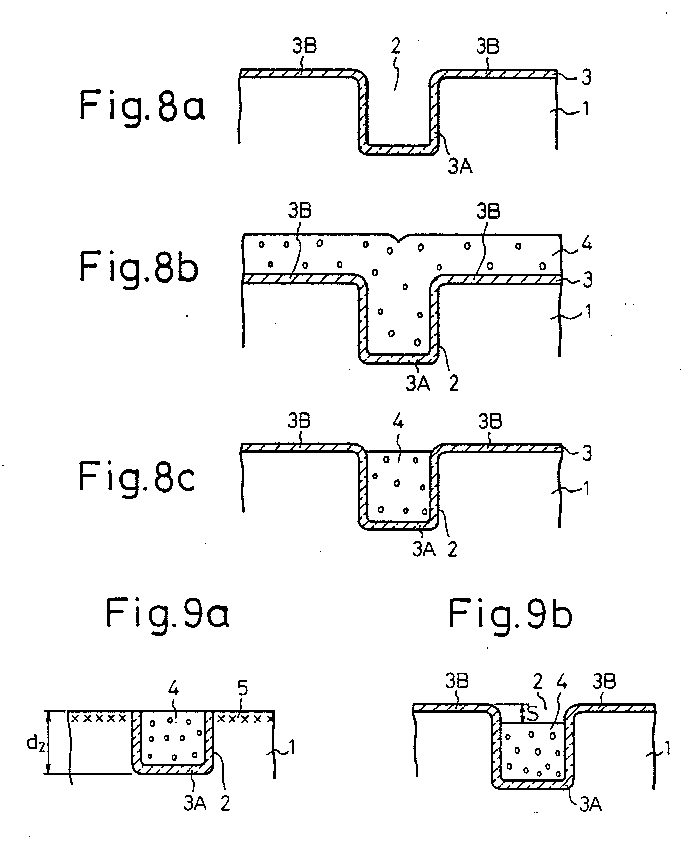

The formation of an element-separating groove having polycrystalline silicon embedded therein is carried out by the steps shown in the sectional views of Figs. 8-(a) through 8-(c).

Referring to Fig. 8-(a), a separating groove 2 is formed on a surface of a semiconductor, for example, a silicon substrate 1, by a usual lithographic method, and a silicon dioxide ($SiO_2$) film 3 acting as a separating-insulating film 3A in the interior of the separating groove 2 and as a stopper film 3B on the top surface of the substrate 1, is formed, for example, by heat oxidation.

Then, as shown in Fig. 8-(b), a polycrystalline silicon layer 4 is formed by the CVD method to a thickness such that the polycrystalline silicon is embedded in the separating groove 2 and the top surface thereof is made substantially flat.

Then, as shown in Fig. 8-(c), the polycrystalline silicon layer 4 is polished by a surface polishing means using a selected polishing liquid until the $SiO_2$ insulating film 3 acting as the stopper film 3B on the top surface of the substrate 1 appears and the polycrystalline silicon 4 remains only in the separating groove 2. An inorganic insulating film such as a silicon nitride ($Si_3N_4$) or $SiO_2$ film formed by the CVD method also can be used as the stopper film.

The polishing liquid for use in the step of polishing the polycrystalline crystalline typically is selected from two types. Polishing liquid (A) is called a "colloidal silica slurry" and is formed by adding colloidal silica to an aqueous solution of an amine type substance such as an alkylamine. Polishing liquid (B) is formed by mixing alumina into an aqueous solution of potassium hydroxide.

Polishing liquid (A) is adapted mainly to the polishing of a silicon substrate cut from an ingot and then lapped. It contains several % of colloidal silica and has a strong mechanical polishing-removing action but a reduced chemical etching of silicon action. A required difference in the polishing speed of the silicon and the insulating film cannot be obtained. Accordingly, the insulating film 3B can not sufficiently exert the required stopper function and is polished and removed together with the polycrystalline silicon layer 4, and as shown in Fig. 9-(a), damage 5 occurs on the surface of the silicon substrate 1 due to the polishing and the depth $d_2$ of the insulating separating film 2 is reduced, with the result that the performance of the semiconductor device fabricated by using this substrate is not acceptable.

Conventional polishing liquid (B) comprises several % of alumina powder having a particle size smaller than 1 $\mu$m, which is incorporated in an aqueous solution containing generally about 10 to about 20% of potassium hydroxide. The polishing liquid (B), unlike the above-mentioned polishing liquid (A), has a strong chemical etching on silicon action, due to the potassium hydroxide, but the mechanical polishing-removing action is relatively weak. Accordingly, the insulating film 3B used as the stopper is not properly polished, and when overpolishing is carried out to uniformly polish the entire surface, the upper part of the polycrystalline silicon layer 4 in the separating groove 2 is etched and a step s is formed at the top of the separating groove 2, as shown in Fig. 9-(b). Therefore, the semiconductor device fabricated by using this substrate is defective in that the yield is reduced due to disconnection or the like.

Moreover, since alumina having a high hardness is used as the abrasive grain in the polishing liquid (B), if the overpolishing is carried out for a long time, the insulating film 3B used as the stopper is simultaneously removed, and the same problem arises as described above with respect to the polishing

2

liquid (A).

Therefore, a primary object of the present invention is to provide a polishing liquid in which wear by polishing of a stopper insulating film is reduced and wear of silicon in the groove by only an etching reaction is prevented, and a polishing process using this polishing liquid.

According to the present invention, the above object can be obtained by a polishing liquid for polishing a semiconductor substrate, which comprises an aqueous solution of an amine selected from the group consisting of ethylenediamine and hydrazine, and 0.04 to 3% by weight of an abrasive grain incorporated in the aqueous solution.

Furthermore, in accordance with the present invention, there is provided a process for polishing a semiconductor substrate, which comprises depositing polycrystalline silicon on a silicon comprising an element-separating groove and an insulating film, which are formed on a silicon substrate, and polishing the polycrystalline silicon with the polishing liquid of the present invention.

In the accompanying drawings:

Figure 1-(a) through 1-(d) are sectional views showing the steps of one embodiment of the polishing process of the present invention;

Fig. 2 is a diagram illustrating the relationship between the processing (polishing) speed and the polishing load during the polishing of polycrystalline silicon;

Fig. 3 is a diagram illustrating the relation ship between the overpolishing quantity and the quantity of silicon polished in the groove;

Fig. 4 is a diagram illustrating the ratios of the polishing rates of Si and $SiO_2$, observed in the polishing liquid of the present invention and in the conventional polishing liquid;

Fig. 5 is a diagram illustrating the relationship between the concentration of ethylenediamine and the processing speed;

Fig. 6 is a diagram illustrating the relationship between the colloidal silica content and the speed of polishing the silicon substrate;

Fig. 7 is a sectional view illustrating the steps of another embodiment of the process of the present invention;

Fig. 8 is a sectional view illustrating the steps of the conventional process; and,

Figs. 9-(a) and 9-(b) are diagrams illustrating the problems of the conventional process.

In the present invention, silica, especially colloidal silica, and a hydroxide of silicon are preferably used as the abrasive grain.

The polishing of silicon with the polishing liquid containing silica or silicon hydroxide in an aqueous solution of ethylenediamine or hydrazine is advanced by the formation of a silicon hydrate film on the surface of the silicon by ethylenediamine or hydrazine, and by a frictional removal of the silicon hydrate film by silica or silicon hydroxide.

The mechanism is the same as the polishing mechanism of a commercially available colloidal silica slurry, i.e., the polishing liquid (A), but in the polishing liquid of the present invention, by using ethylenediamine or hydrazine having a higher oxidizing force than the amine type substance as the oxidizer for silicon, the thickness of the silicon hydrate film formed on the silicon surface is increased, and as this thick silicon hydrate film can be peeled off by a low mechanical external force the content of the abrasive grain in the polishing liquid of the present invention can be made much lower than in the conventional polishing liquid, and thus a silicon polishing rate several times higher than the silicon polishing rate in the conventional technique can be obtained.

Ethylenediamine or hydrazine does not exert a chemical action on the insulating film used as the polishing stopper, and since the polishing rate of the insulating film is determined by the content of the abrasive grain, the polishing rate of the insulating film is very low in the polishing liquid of the present invention, in which the content of the abrasive grain is low.

Furthermore, the thickness of the silicon hydrate film formed by the above-mentioned oxidation is limited to up to several hundred Å and the oxidation is not further advanced, and the abrasive grain content is very low. Therefore, the silicon hydrate film located below the top surface of the stopper insulating film is not removed, and thus a step is not formed in the upper portion of the groove when silicon is embedded in the groove.

The above-mentioned advantages are especially noticeable when colloidal silica is used as the abrasive grain, and these advantages can be also obtained when a hydroxide of silicon is used instead of colloidal silica.

If the polishing liquid and polishing method of the present invention are used for polishing polycrystalline silicon by using the insulating film as the stopper, the polishing rate of silicon can be greatly increased without damage to the insulating film as the polishing stopper, and since the silicon surface exposed from the stopper film is not deeply polished, the polishing precision is increased.

The present invention will now be described in detail with reference to the accompanying drawings.

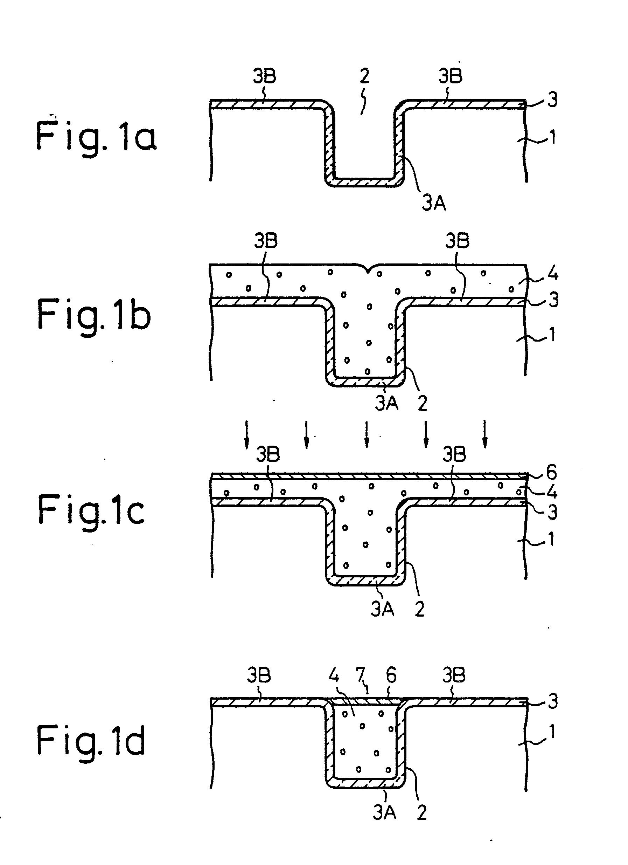

Figure 1-(a) through 1-(d) are sectional views showing the steps of one embodiment of the polishing process of the present invention;

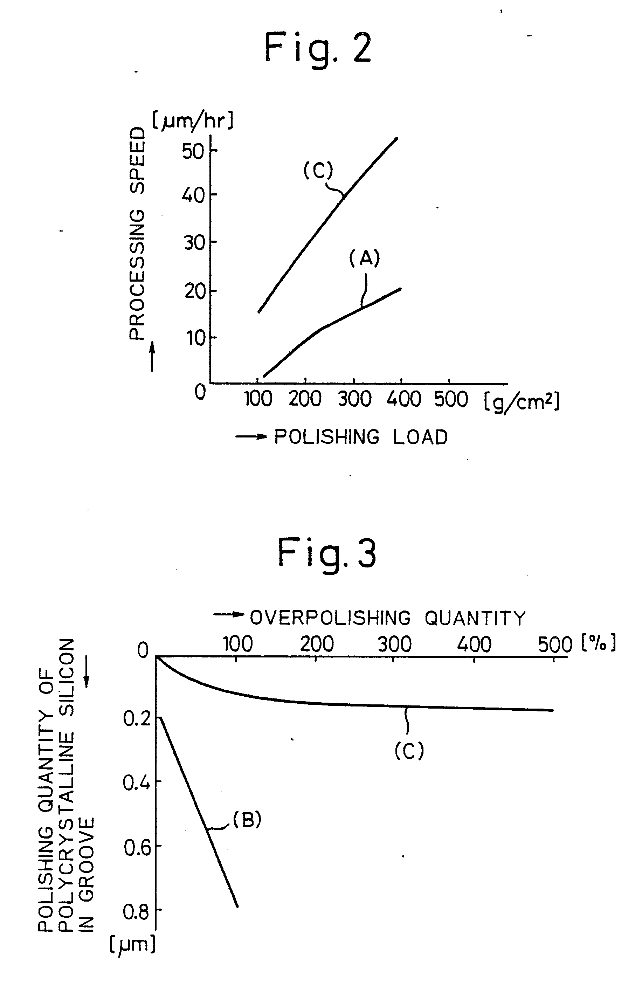

Fig. 2 is a diagram illustrating the relationship between the processing (polishing) speed and the polishing load when polishing polycrystalline silicon;

Fig. 3 is a diagram illustrating the overpolishing quantity and the quantity of silicon polished in the groove;

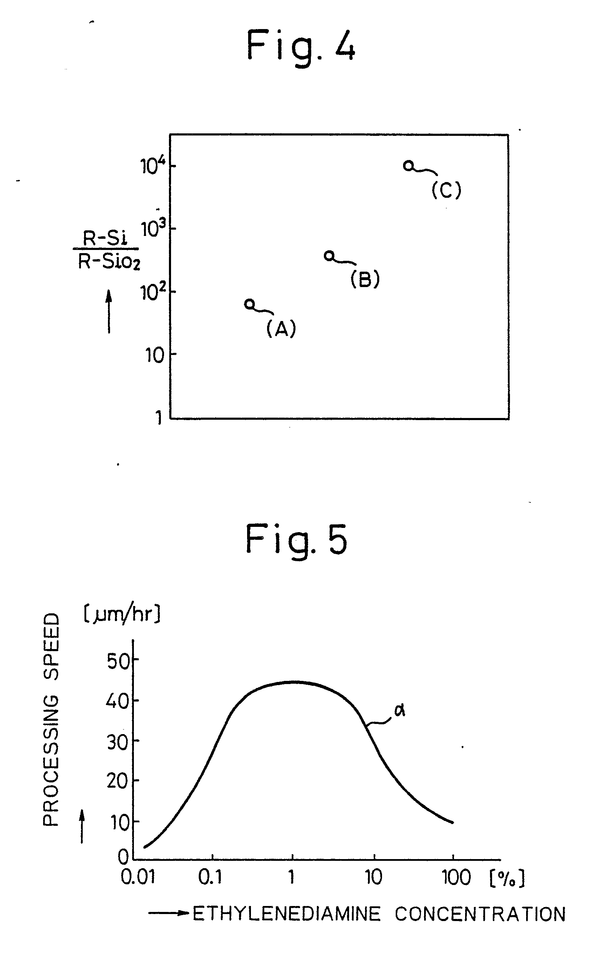

Fig. 4 is a diagram illustrating the ratios of the polishing rates of Si and $SiO_2$ in the polishing liquid of the present invention and in the conventional polishing liquid;

Fig. 5 is a diagram illustrating the relationship between the ethylenediamine concentration and the processing speed;

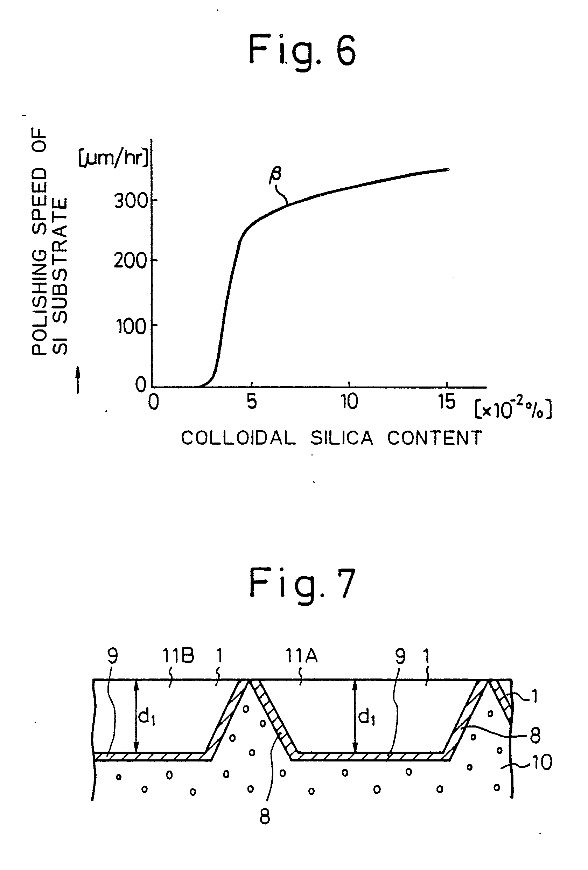

Fig. 6 is a diagram illustrating the relationship between the colloidal silica content and the speed of polishing the silicon substrate; and

Fig. 7 is a sectional view showing the steps of another embodiment of the process of the present invention.

Throughout the drawings, the same members are indicated by the same reference numerals and symbols.

All of "%" of the mixing ratios are by weight.

Referring to Fig. 1-(b), when an insulating separating region is formed between elements in a semiconductor device according to the process of the present invention, a separating groove 2 having, for example, a width of 2 μm and a depth of about 2 μm, is formed on a silicon substrate 1 having a predetermined conductivity and a predetermined impurity concentration, by a usual photolithography method, and then an $SiO_2$ film 3 having a thickness of about 0.1 to about 0.2 μm, inclusive of the inner surface of the separating groove 2, is formed on the surface of the silicon substrate 1. This $SiO_2$ film 3 acts as a separating insulating film 3A in the separating groove 2 and acts as a polishing stopper film 3B on the top surface of the silicon substrate 1.

Referring to fig. 1-(b), and undoped polycrystalline layer 4 is formed on the silicon substrate 1 by the CVD method to a thickness of, for example, about 1.5 μm, whereby polycrystalline silicon is embedded in the separating groove 2 and the top surface thereof is substantially flat.

Referring to fig. 1-(c), a polishing liquid of the present invention, for example, a polishing liquid formed by adding about 0.4% of colloidal silica (having an average particle size of 0.05 μm) to a 3% aqueous solution of ethylenediamine, is poured onto the top surface of the substrate and the top surface of the substrate, i.e., the top surface of the polycrystalline silicon layer 4, is chemically and mechanically polished (mechanochemical polishing) by using a usual surface polishing disc having a hard abrasive cloth bonded thereto.

By this polishing, a silicon hydrate film 6 having a composition of $Si(OH)_x$ and a thickness of several hundred Å is formed on the surface of the polycrystalline silicon layer 4, by the above-mentioned strong oxidizing action of ethylenediamine, and this silicon hydrate film 6 is peeled off by friction with the colloidal silica to advance the polishing. Figure 1-(c) shows the state during this polishing.

Figure 2 is a diagram illustrating the relationship between the processing (polishing) speed and the polishing load during the polishing of the polycrystalline silicon. In Fig. 2, a curve (C) indicates the processing speed obtained when the polishing liquid (C) formed by adding 0.4% of colloidal silica to the 3% aqueous solution of ethylenediamine according to the present invention is used, and a curve (A) indicates the processing speed obtained in the conventional process when a commercially available polishing liquid (A) called a "colloidal silica slurry", which is formed by adding several% of colloidal silica to the above-mentioned water-soluble alkylamine, is used.

The data shown in Fig. 2 is obtained by using a one-surface vacuum attraction system polishing apparatus including a surface plate (polishing disc) having a diameter of 400 mm. As seen from Fig. 2, although the content of colloidal silica in the polishing liquid (C) of the present invention is about 1/10 of the colloidal silica content in the commercially available colloidal silica slurry (A), the polishing speed obtained by the polishing liquid (C) is at least twice the polishing speed obtained by the commercially available colloidal silica slurry (A) under the same polishing load. This is because the thickness of the hydrate film formed by an oxidation of the silicon is larger than the thickness obtained by the conventional technique.

Note, in the above operation, the processing load is adjusted to 400 g/cm² and a non-woven polishing cloth for the primary polishing (SUBA-500 supplied by Rodel Co.) is used as the abrasive cloth.

Referring to Fig. 1-(d), the polishing is continued, and after the $SiO_2$ film 3 acting as the stopper film 3B is exposed, to completely effect the polishing of the entire surface of the substrate, overpolishing is carried out to a degree of about +100% in terms of time, whereby an element-separating insulating region 7 comprising the polycrystalline silicon layer 4 embedded almost to the top surface in the separating groove 2 through the $SiO_2$ film 3 acting as the insulating film is completely formed.

Finally, a dipping treatment is carried out at room temperature by using, for example, an aqueous solution of HF, and thus the polishing process completed.

In the above-mentioned embodiment, the separating groove 2 is first formed on the silicon substrate 1 and then the $SiO_2$ insulating film 3 is formed on the surface. If desired, a modification can be adopted in which the insulating film 3 is first formed on the silicon substrate 1, the element-separating groove 2 is then formed, and the $SiO_2$ insulating film 3A is formed in this groove. Alternatively, a modification can be adopted in which as $Si_3N_4$ film is formed instead of the $SiO_2$ film. In this case, a method can be adopted in which a thin $SiO_2$ film is first formed and the $Si_3N_4$ film is then formed thereon.

Figure 3 is a diagram illustrating the relationship between the overpolishing quantity (unit: %) expressed in terms of time and the polishing quantity (unit: $\mu m$) of polycrystalline silicon in the separating groove 2. When the polishing liquid (c) of the present invention used in the above-mentioned embodiment is used, as indicated by curve (c), in the case of the overpolishing by 100%, the polishing quantity of polycrystalline silicon in the separating groove is about 0.1 to about 0.12 $\mu m$, and even if an overpolishing by about 500% is carried out, the polishing quantity is less than 0.2 $\mu m$ and the manufacturing yield is not adversely affected. In contrast, in the conventional polishing liquid (B) obtained by adding alumina to a solution of potassium hydroxide, as indicated by the curve (B), the polishing margin is about 30% at highest. The noticeable increase of the polishing margin obtained by the polishing liquid (c) of the present invention greatly contributes to a stabilization of the polishing quality.

Figure 4 shows the ratio (R-Si/R-SiO$_2$) of the polishing rate of the silicon and the polishing rate of the $SiO_2$ film as the polishing stopper, when using the polishing liquid (C) of the above embodiment, the conventional colloidal silica slurry (A), and the (KOH + $Al_2O_3$) polishing liquid (B). As is shown in Fig. 4, the polishing rate ratio of the polishing liquid (C) of the present invention is about 10 to about 100 times higher than those of the conventional liquids (A) and (B). Accordingly, when the polishing liquid of the present invention is used, the $SiO_2$ film 3 as the polishing stopper is not damaged by the polishing.

Figure 5 is a diagram illustrating the relationship between the concentration of ethylenediamine and the processing speed, when the colloidal silica content is fixed at 0.4%. As indicated by curve $\alpha$, to obtain a relatively high processing speed, preferably the concentration of ethylenediamine is 0.1 to 10%, more preferably 0.5 to 3%.

When the polishing liquid is circulated and used repeatedly, the silicon hydrate removed by the polishing is dispersed in the polishing liquid to exert a function similar to that of colloidal silica. The polishing rate of this dispersed silicon hydrate to the $SiO_2$ film as the stopper is less than 1/10 of the polishing rate of colloidal silica (based on the same weight calculated as silicon), and accordingly, the polishing rate of silicon can be further increased without damage to the $SiO_2$ film as the stopper, and the above-mentioned advantages of the polishing process are enhanced.

Figure 6 is a diagram illustrating the relationship between the colloidal silica content and the polishing speed of the silicon substrate, when the polishing liquid is used in the circulation system and the concentration of ethylenediamine is maintained at 3%. As indicated by curve B, the polishing speed abruptly rises when the colloidal silica content is about 0.04%, and a very high polishing speed can be obtained, and even if the colloidal silica content is further increased, the polishing speed is not increased. Accordingly, the colloidal silica content must be at least 0.04%. In view of the foregoing, to obtain a high polishing speed and increase the polishing accuracy while reducing damage to the stopper film, preferably the colloidal silica content is about 0.1 to about 0.5%.

Note, the colloidal silica content and the ethylenediamine concentration are changed according to the kind of the polishing cloth and the polishing conditions. For example, when a soft polishing cloth is used, a high polishing speed cannot be obtained unless the colloidal silica content is increased, but to control damage to the insulating film as the stopper, preferably the colloidal silica content does not exceed 3%.

In the foregoing embodiment, the data shown in Figs. 3 through 6 is obtained by adopting the same apparatus and conditions as in Fig. 2, except that a foamed polyurethane type polishing cloth (Surfin-018 supplied by Fujimi Kenmazai) for the primary polishing is used as the polishing cloth in Fig. 3 and a processing pressure of 1 kg/cm$^2$ is adopted in Fig. 6.

Various patterns can be adopted for the semiconductor element-separating groove (isolation groove) according to the arrangement of the semiconductor elements. The level of the polycrystalline silicon in the groove is lower (by up to 0.2 $\mu m$) than the mask surface, and convexities and concavities corresponding to the pattern of the separating groove appear on the surface.

The polishing cloth causes a viscoelastic deformation due to these convexities and concavities, and therefore, the insulating film of the mask is not uniformly polished and a seriously damaged portion according to the pattern exists. In this portion, the region surrounded by the element-separating groove is smaller than in other portions, or the density of the region surrounded by the element-separating groove is lower than in other portions. If a portion exists in which the region surrounded by the element-separating groove is small and the density of the region surrounded by the element-separating groove is low, this portion is most heavily damaged. Accordingly, a state where a region of 2 $\mu$m x 4 $\mu$m surrounded by an element-separating groove having a width of 2$\mu$m is separated by 5 mm from another separating groove is produced, and the polishing test is carried out. The reason why these values were selected is that, if satisfactory results are obtained in this state, usual element-separating grooves can be satisfactorily polished. Many variable conditions such as the polishing pressure, the rotation number of the surface plate, the feed rate of the polishing liquid, and the abrasive grain concentration are involved in the polishing operation, but as the result of an experiment conducted at the same overpolishing ratio (%) based on the time required for completion of the polishing operation, it was found that the concentration of the abrasive grain has the most influence on the damage to the insulating film. The results of the experiment conducted by using the above-mentioned pattern are shown in Table 1. Note, the processing pressure was 400 g/cm$^2$ and the rotation number of the surface plate was 150 rpm.

Table 1

| Concentration (%) of Colloidal Silica | R-Si/R-SiO$_2$ Ratio | Overpolishing Margin |
|---|---|---|
| 0 | polishing impossible | - |
| 0.1 | about 2.3 x 10$^3$ | 500% |
| 0.3 | about 1.5 x 10$^3$ | 300% |
| 1.3 | about 0.7 x 10$^3$ | 200% |
| 2 | about 2.6 x 10$^2$ | 80% |
| 3 | about 2.0 x 10$^2$ | 40% |
| 3.5 | about 1.6 x 10$^2$ | 20% |

By the overpolishing margin is meant the margin producing a state where no problems arise at the subsequent step after embedding polycrystalline silicon into the element-separating groove by the polishing. As pointed out, where after completion of the polishing it is possible to further conduct the polishing for the same time as the time required for the polishing, the overpolishing margin is 100%. As seen from the data shown in Table 1, overpolishing margin exists even if the colloidal silica concentration exceeds 3%, but to perform the polishing stably, most preferably the colloidal silica concentration is up to 3%. If the colloidal silica concentration is further reduced, the overpolishing margin becomes larger and the control is easily obtained, but if colloidal silica is not contained, the polishing becomes impossible and the polishing liquid cannot be practically used.

If the ethylenediamine concentration is lower than 10%, good results can be obtained under various polishing conditions, but if the ethylenediamine concentration exceeds this level, the processing speed is reduced.

Where hydrazine (N$_2$H$_4$) is used instead of ethylenediamine, the same results as obtained in the foregoing embodiment can be obtained at the same hydrazine concentration and colloidal silica content as adopted in the foregoing embodiment.

Where the polishing liquid of the present invention contains a hydroxide of silicon, Si(OH)$_x$ , in an amount almost equal to the above-mentioned amount of colloidal silica in an aqueous solution of ethylenediamine or hydrazine, effects similar to those obtained in the foregoing embodiment can be obtained.

To prevent the formation of projections on the polished surface, the hydrogen ion concentration (pH value) can be adjusted by potassium hydroxide (KOH) or the like.

The present invention can be effectively applied not only to the embedding of polycrystalline silicon in the insulating separating groove, as shown in the foregoing embodiment, but also to the formation of a dielectric substance-separated substrate.

In this case, as shown in Fig. 7, a V-shaped groove 8 having a depth of about 40 to about 50 $\mu$m is formed on a silicon substrate 1, and an SiO$_2$ dielectric film 9 having a thickness of about 2 $\mu$m is formed on the surface of the substrate 1. A polycrystalline silicon layer 10 having a thickness of about 500 $\mu$m is

formed as the base on the surface, inclusive of the inner surface of the V-shaped groove 8, of the substrate 1, and the silicon substrate 1 is plane-polished from the back surface until the SiO2 dielectric film 9 on the top end of the V-shaped groove 8 is exposed whereby a dielectric substance-separated substrate having single crystal silicon bases 11A and 11B arranged in the form of islands separated and defined by the V-shaped groove 8 having the dielectric film 9 on the polycrystalline silicon substrate 10, is formed.

If the polishing liquid of the present invention is used for polishing the substrate 1, the SiO2 dielectric film 9 on the top end of the V-shaped groove 8 acts as a stopper film, and the polishing speed in the portion where the SiO2 dielectric film 9 is exposed is about 1/250 of the polishing speed in the portion where the SiO2 dielectric film is not exposed. Accordingly, the polishing accuracy of the depth $d_1$ of the island-like regions 11A and 11B of single crystal silicon can be maintained within $\pm 3$ $\mu$m when a substrate having a thickness of 4 inches is used. This value is a great improvement over the value of $\pm 7$ $\mu$m obtained in the conventional technique.

A silicon nitride ($Si_3N_4$) film can be used as the insulating film acting as the polishing stopper, instead of the above-mentioned SiO2 film.

As apparent from the foregoing description, according to the present invention, in the polishing of a semiconductor substrate comprising a substrate or a growing layer, especially a semiconductor substrate comprising an insulating film of SiO2 or $Si_3N_4$ as a polishing stopper, the polishing speed and polishing accuracy can be improved, and the overpolishing margin for maintaining the accuracy and quality can be increased.

Therefore, the present invention is effective for improving the manufacturing yield of a semiconductor device having an insulating separating film structure or a dielectric substance-separated structure.

## Claims

1. A polishing liquid for polishing a semiconductor substrate, which comprises an aqueous solution of an amine and in which an abrasive granular substance is incorporated, characterised in that the amount of abrasive is 0.04 to 3% by weight and the amine is selected from the group consisting of ethylenediamine and hydrazine.

2. A polishing liquid as set forth in claim 1, wherein the abrasive grain is composed of silica.

3. A polishing liquid as set forth in claim 2, wherein the amount of silica is 0.1 to 0.5% by weight.

4. A polishing liquid as set forth in claim 1, wherein the abrasive grain is composed of a hydroxide of silicon.

5. A polishing liquid as set forth in any preceding claim, wherein the amine concentration in the aqueous solution of the amine is 0.1 to 10% by weight.

6. A polishing liquid as set forth in any preceding claims, wherein the amine concentration is 0.5 to 3% by weight.

7. A polishing liquid as set forth in any preceding claim, for polishing a semiconductor substrate on the surface of which a polycrystalline silicon is deposited.

8. A process for polishing a semiconductor substrate, which comprises depositing polycrystalline silicon on a semiconductor substrate having an element-separating groove and a stopper film, which are formed on a semiconductor substrate surface, and polishing the polycrystalline silicon with a polishing liquid according to any preceding claim.

9. A process according to claim 8, wherein the insulating film is selected from the group consisting of an SiO2 film and an $Si_3N_4$ film.

Fig.1a

Fig.1b

Fig.1c

Fig.1d

# Fig. 2

# Fig. 3

# Fig. 4

$\dfrac{R\text{-}Si}{R\text{-}SiO_2}$ (vertical axis)

Points: (A), (B), (C)

# Fig. 5

PROCESSING SPEED [μm/hr]

ETHYLENEDIAMINE CONCENTRATION [%]

# Fig. 6

# Fig. 7

Fig.8a

Fig.8b

Fig.8c

Fig.9a

Fig.9b

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | FR-A-2 216 077 (WACKER-CHEMITRONIC) <br> * page 5, lines 1-21 * | 1-6 | C 09 K 3/14 <br> H 01 L 21/304 |
| X | US-A-4 169 337 (NALCO CHEMICAL CO.) <br> * Page 1, line 54 - page 2, line 46 * | 1,2,4,5 | |
| A | DD-B- 125 140 (D. AHLBRECHT et al.) <br> * Page 4, lines 88-106 * | 1,2 | |
| X | DE-A-2 248 719 (A.A. SERAFIMOWITSCH et al.) <br> * Page 17, example 4 * | 1,2 | |
| A | | 5 | |
| A | EP-A-0 274 801 (PHILIPS) <br> * Abstract; figure 6 * | 1,7-9 | |
| A | IEEE TRANSACTIONS ON ELECTRON DEVICES, vol. ED-30, no. 12, December 1983, pages 1785-1791, IEEE, New York, US; T. FUKUSHIMA et al.: "An advanced SVG technology for 64K junction-shorting PROM's" <br> * Figure 1 * | 1,7-9 | TECHNICAL FIELDS SEARCHED (Int. Cl.5) <br><br> H 01 L |
| A | EP-A-0 224 646 (IBM CORP.) <br> * Claim 11; figures 7,8; abstract * | 1,2,7-9 | |
| A | INTERNATIONAL ELECTRON DEVICES MEETING, Washington, DC, 1st-4th December 1985, pages 688-691, IEEE, New York, US; T. HAMAGUCHI et al.: "Novel LSI/SOI wafer fabrication using device layer transfer technique" <br> * Figure 2 * | 1,2,4,8,9 | |

The present search report has been drawn up for all claims

| Place of search | Date of completion of the search | Examiner |
|---|---|---|
| THE HAGUE | 16-11-1989 | GELEBART J.F.M. |

EPO FORM 1503 03.82 (P0401)